# DEMANDE DE BREVET EUROPEEN

(11) **EP 0 743 377 A1**
(43) Date de publication de la demande: **20.11.1996**
(21) Numéro de dépôt: 96401055.7
(22) Date de dépôt: 14.05.1996
(51) Int. Cl.: C23C 16/44, C23C 16/48, C30B 25/10

(54) **Dispositif de traitement chimique superficiel d'un échantillon plat au moyen d'un gaz actif**

(30) Priorité: 19.05.1995 FR 9505980
(71) Demandeur: COMMISSARIAT A L'ENERGIE ATOMIQUE, 75015 Paris (FR)
(72) Inventeur: Mermet, Jean-Luc, 38400 St Martin D'Heres (FR)
(74) Mandataire: Dubois-Chabert, Guy

(57) **Abrégé**

Le dispositif de traitement chimique permet d'effectuer des revêtements sur des tranches de silicium à basses pressions et des recuits sous vide, sans laisser des dépôts sur des pièces support de l'échantillon ou sur la face arrière de ce dernier.

Il comprend principalement un support annulaire (16, 20) sur lequel l'échantillon (11) est posé, séparant ainsi la chambre de réaction (12) en deux volumes supérieur (22) et inférieur (21). Le volume supérieur (22) bénéficie d'une circulation de gaz actif, tandis que le volume inférieur (21) bénéficie d'une circulation de gaz neutre à une pression très légèrement inférieure. On utilise des moyens de mesure de pression différentielle (24) et deux vannes de régulation (25, 27) pour asservir ces deux pressions.

Application à la réalisation de dépôts ou de gravure de couches minces sur des disques de silicium.

## Description

### Domaine technique

L'invention concerne la gravure ou le dépôt de couches minces par réaction chimique sur une surface d'un échantillon plat. On pense en particulier à l'utilisation de dispositifs permettant la réalisation de réactions chimiques en phase vapeur du type "réacteurs à murs froids", c'est-à-dire où seul l'échantillon, sur lequel le traitement doit être effectué, est porté à la température requise, tandis que les parois du dispositif sont maintenues à basse température. Ce type de réacteurs est notamment utilisé dans l'industrie de la microélectronique, pour réaliser ou graver des couches minces ayant des propriétés électriques spécifiques, conductrices ou isolantes. Les échantillons utilisés sont alors des disques de silicium de diamètre compris entre 100 et 200 mm.

Le domaine de la métallurgie est également concerné pour les revêtements des pièces mécaniques diverses en vue de modifier la dureté et les propriétés thermiques et électriques des surfaces de ces pièces.

L'invention peut également être utilisée dans le domaine de l'optique, pour déposer des films réflecteurs ou absorbants.

### Art antérieur et problèmes posés

Différentes techniques sont actuellement utilisées pour réaliser des dépôts sur une seule surface d'un échantillon plat, tel qu'une plaque de silicium. Néanmoins, plusieurs problèmes techniques imposent des contraintes de conception.

Par exemple, la fixation de l'échantillon sur son support peut être réalisée, soit par serrage, soit par aspiration sur le support. L'échantillon peut être également simplement posé sur celui-ci.

L'élément chauffant n'est généralement jamais en contact avec les parois de la cellule à l'intérieur de laquelle est placé l'échantillon. Il peut se trouver soit à l'extérieur de la cellule, soit à l'intérieur et constituer ainsi en même temps le support de l'échantillon. Le chauffage peut être effectué par effet Joule ou par effet de rayonnement.

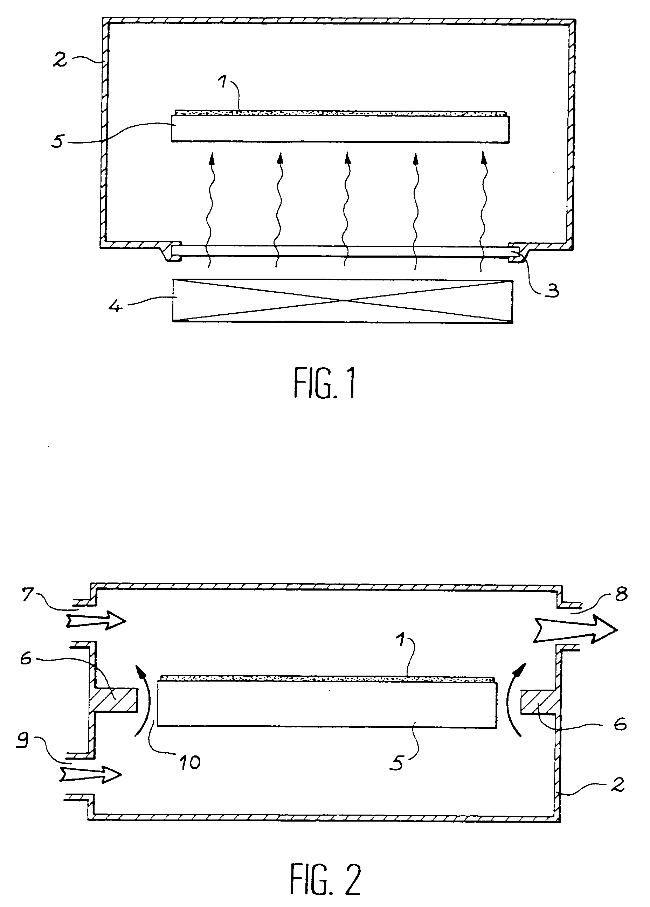

La figure 1 représente schématiquement une de ces solutions déjà utilisées. On y voit un échantillon plat 1 posé sur un support d'échantillon 5 sans fixation spéciale. Ces deux éléments sont placés à l'intérieur d'une chambre de réaction 2 qui possède, dans sa partie inférieure, une paroi transparente au rayonnement 3 d'un élément chauffant radiatif 4. Ceci permet à ce dernier d'être placé à l'extérieur de la chambre, en regard de cette paroi transparente 3. Ainsi, comme le schématisent les flèches, un rayonnement thermique peut être transmis au support d'échantillon 5 chauffant lui-même l'échantillon 1.

Un problème de conduction thermique entre le support d'échantillon 5 et l'échantillon 1 se pose lorsque la pression à l'intérieur de la chambre est inférieure à environ 10 Torr (1 330 Pa). En effet, une très mince couche de gaz d'épaisseur microscopique reste entre l'échantillon 1 et son support d'échantillon 5, les surfaces respectives de ceux-ci ne pouvant pas être parfaitement planes. Du fait que cette sorte de lame de gaz possède une forte résistance thermique et que son épaisseur varie fortement d'un point à l'autre, la montée en température de l'échantillon est loin d'être homogène sur toute la surface de ce dernier.

Cet inconvénient peut être évité lorsque la pression entre l'échantillon 1 et son support 5 est maintenue supérieure à 10 Torr (1 330 Pa) par une injection de gaz à cet endroit. Par contre, ceci interdit l'utilisation de faibles pressions, sous peine de voir se soulever l'échantillon de son support, à moins de le maintenir mécaniquement avec des moyens de serrage qui se trouvent alors soumis aux mêmes réactions chimiques que l'échantillon et recouverts du même dépôt. Le dispositif s'encrasse alors très rapidement.

D'autre part, en référence à la figure 2, on connaît un moyen d'éviter le dépôt ou la réaction sur la partie inférieure du support d'échantillon 5. Compte tenu du fait qu'un gaz actif est souvent utilisé pour effectuer ce dépôt, on s'arrange pour que la circulation de celui-ci soit confinée dans la partie supérieure par une entrée supérieure 7 et une sortie supérieure 8 placées de part et d'autre, de sorte que ce courant de gaz actif ne vienne atteindre que la surface supérieure de l'échantillon 1. On utilise alors des cloisons latérales 6 au niveau du support d'échantillon 5. On évite que la réaction n'ait lieu sur la partie inférieure du support d'échantillon 5 en utilisant un gaz neutre, introduit par une entrée inférieure 9 en dessous du support d'échantillon 5. Les espaces 10 subsistant entre le support d'échantillon 5 et les cloisons latérales 6 permettent à ce gaz neutre de se mélanger au gaz actif pour être évacué par la sortie supérieure 8. Ainsi, les parties latérales et inférieures du support d'échantillon 5 ne sont pas atteintes par le dépôt effectué sur la surface supérieure de l'échantillon 1. Cependant, ce procédé ne limite pas le dépôt parasite se produisant sur la face arrière de l'échantillon 1, n'évite pas la réalisation d'un dépôt qui ne serait pas homogène, empêche l'utilisation de faible pression et ne remédie pas au manque de contrôle de la température.

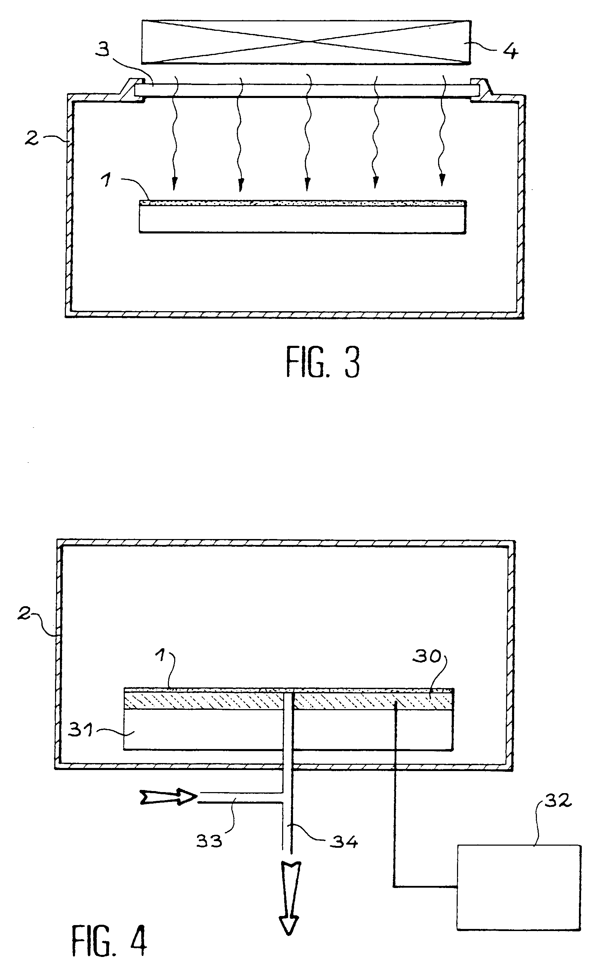

Le cas de la figure 3 ressemble à celui de la figure 1, l'élément 4 chauffant étant placé au-dessus. Ici, la température de l'échantillon 1 est difficile à contrôler du fait de l'évolution de la surface, et donc de son coefficient d'absorption du rayonnement, au fur et à mesure que la couche mince croît. Cette difficulté rend incontrôlables certains procédés, notamment ceux où il y a une forte différence d'absorption entre le substrat de départ et le matériau qui y est déposé : une forte variation de température se produit lors de l'amorçage du dépôt.

Enfin, dans le cas de la figure 4, une haute tension est appliquée, au moyen d'un générateur haute tension 32 sur le support 31, isolé électriquement de l'échantillon 1 par un élément en céramique ou en polymère 30. Cette tension induit un déplacement de charges dans l'échantillon 1 qui se trouve plaqué, par attirance électrostatique, sur son support. Cette force étant relativement importante, une certaine étanchéité existe sur la périphérie du substrat, entre d'une part la zone comprise entre l'échantillon 1 et son support 31 et d'autre part le reste du réacteur. Au moyen de deux conduites 33 et 34, une pression de gaz neutre d'environ 10 T (1 330 Pa) peut donc être maintenue sous l'échantillon 1 pour améliorer le contact thermique, même si la pression de procédé est basse dans le réacteur ; celle-ci cependant ne peut être inférieure à 10⁻⁴ T (0,1 Pa), ce qui exclu les traitements sous vide poussé.

L'inconvénient essentiel de cette technique réside dans sa limitation en température. En effet, les céramiques ont toutes la propriété de devenir conductrices électriques à haute température. Ceci limite à 300°C environ l'utilisation possible de ce type de support. Par ailleurs, l'écrantage dû à l'électrode haute tension crée des inhomogénéités de température sur l'échantillon 1. Enfin, ces supports 31 ne peuvent être utilisés pour des recuits de substrats sous vide secondaire ou ultra-vide, comme cela a été mentionné ci-dessus.

### Résumé de l'invention

Le but de l'invention est de fournir un dispositif permettant d'appliquer différentes pressions et températures, de façon indépendante du procédé mis en oeuvre, de maintenir l'échantillon à une température homogène, même à basse pression, de ne pas avoir de pièces mécaniques atteignant une température voisine de celle de l'échantillon, de ne pas provoquer de dépôt sur la face arrière de l'échantillon et de pouvoir utiliser le support d'échantillon pour un traitement sous pression et un traitement sous vide tout en maîtrisant les différentes pressions sur les deux faces.

A cet effet, l'objet principal de l'invention est un dispositif de traitement chimique superficiel à température élevée d'une seule surface d'un échantillon plat au moyen d'un gaz actif par réaction chimique, le dispositif comprenant :
- une chambre de réaction ;
- un support d'échantillon placé dans la chambre de réaction et constitué d'un épaulement de support annulaire entièrement fixé à l'intérieur de la chambre de réaction et sur lequel l'échantillon doit être posé de manière à partager l'intérieur de la chambre en deux volumes séparés, qui sont un volume supérieur et un volume inférieur ;
- des moyens de circulation d'un premier gaz, par exemple actif, sur la surface à traiter de l'échantillon ;
- des moyens de circulation d'un deuxième gaz, par exemple neutre, dans le volume inférieur, sur une deuxième surface à traiter de l'échantillon ; et
- un élément chauffant radiatif placé à l'extérieur et près de la chambre de réaction.

Selon l'invention, on utilise des moyens de mesure et des moyens de commande des pressions respectives des volumes supérieur et inférieur de la chambre de réaction, pour asservir les pressions dans ces deux volumes supérieur et inférieur avec le traitement chimique à appliquer à l'échantillon.

De préférence, les moyens de commande sont constitués d'une vanne de régulation pour chacun des volumes inférieur et supérieur.

Dans le but de faciliter le maintien de l'échantillon sur son support et d'éviter le passage du premier gaz en face arrière de l'échantillon, la pression de circulation PS du premier gaz dans le volume supérieur de la chambre de réaction est très légèrement supérieure à la pression PI du deuxième gaz dans le volume inférieur de la chambre de réaction. En d'autres termes, ces pressions sont réglées de sorte que l'échantillon soit soumis à une force verticale résultante, vers le haut, inférieure à son poids.

L'élément radiatif est placé en-dessous d'une paroi inférieure de la chambre de réaction, cette paroi se trouvant elle-même juste en-dessous de la bague support et de l'échantillon.

De préférence, la paroi inférieure de la chambre de réaction est en un matériau fortement transparent aux longueurs d'ondes du rayonnement émis par l'élément radiatif.

On peut utiliser des moyens de mesure de la pression PS dans le volume supérieur et une deuxième vanne de régulation placée sur les moyens de circulation du gaz actif, pour asservir la pression PS de réaction dans le volume supérieur.

### Liste des figures

L'invention et ses différentes caractéristiques techniques seront mieux comprises à la lecture de la description suivante, accompagnée de quelques figures représentant respectivement :
- figure 1, schématiquement, un premier dispositif de l'art antérieur ;
- figure 2, schématiquement, un deuxième dispositif de l'art antérieur ;
- figure 3, schématiquement, un troisième dispositif de l'art antérieur ;
- figure 4, schématiquement, un quatrième dispositif de l'art antérieur ;
- figure 5, un schéma de fonctionnement du dispositif selon l'invention ;
- figure 6, en coupe frontale, une principale réalisation d'un dispositif selon l'invention.

### Description détaillée d'une réalisation de l'invention

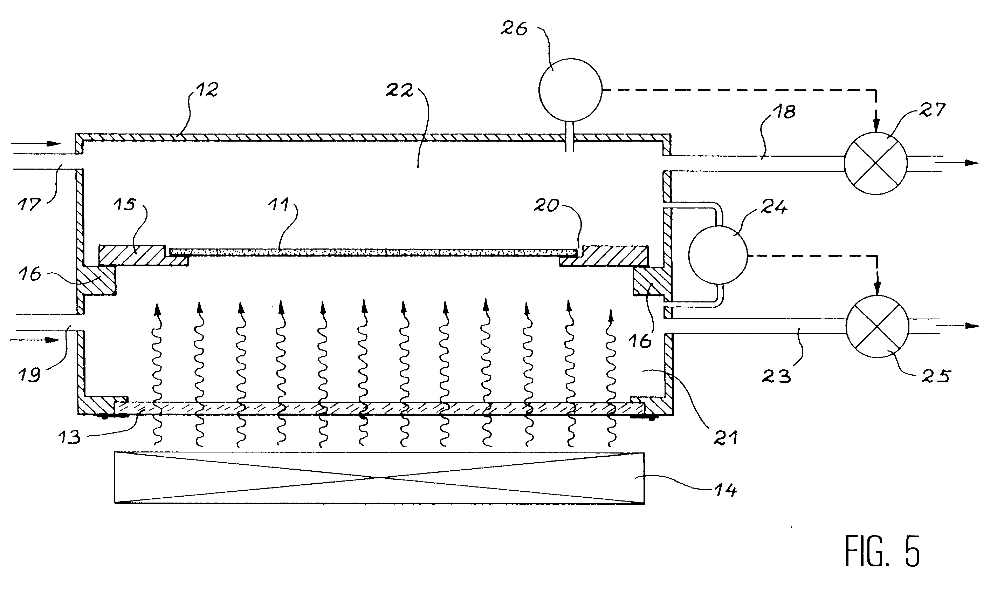

Le principe du dispositif selon l'invention est schématisé par la figure 5. On retrouve sur cette figure des éléments déjà évoqués dans les dispositifs donnés en exemples dans l'art antérieur. Plus précisément, on y retrouve une chambre de réaction 12 de forme légèrement allongée horizontalement, mais, selon l'invention, équipée d'un épaulement annulaire 16 sur la paroi interne de la chambre, à mi-hauteur de celle-ci.

L'échantillon 11 est placé sur cet épaulement 16, de préférence par l'intermédiaire d'une bague amovible 15 prenant appui elle-même sur l'épaulement 16. Cette bague support 15 possède de préférence une petite encoche 20 dans laquelle est placé l'échantillon 11, de manière à ce que ce dernier soit positionné de façon centrée au milieu de la chambre de réaction 12.

Un élément chauffant radiatif 14 est placé en-dessous d'une paroi inférieure 13 de la chambre de réaction 12. Cet élément chauffant radiatif émet un rayonnement thermique qui traverse la paroi inférieure 13 transparente à la longueur d'onde du rayonnement émis. Ce dernier atteint la surface inférieure de l'échantillon 11 et le chauffe de manière homogène sur toute sa surface, excepté les quelques millimètres périphériques prenant appui sur la bague amovible 15. On précise que la conduction thermique à l'intérieur de l'échantillon 11 permet au bord de l'échantillon 11 d'être chauffé à la même température que le reste de l'échantillon 11. La bague amovible 15 peut également être transparente pour favoriser la répartition des rayonnements.

On constate ainsi que l'échantillon 11 partage le volume interne de la chambre de réaction 12 en deux volumes, un volume inférieur 21 et un volume supérieur 22 qui sont séparés l'un de l'autre.

Dans son volume supérieur 22, la chambre de réaction 12 possède une première entrée de gaz 17 sur un de ses côtés et une première sortie de gaz 18 sur le côté opposé à l'entrée 17. Ainsi, une circulation de gaz actif peut être organisée dans ce volume supérieur 22 et balayer la surface supérieure de l'échantillon 11 à traiter.

De façon analogue, une deuxième entrée de gaz neutre 19 est prévue sur un côté du volume inférieur 21 de la chambre de réaction et une deuxième sortie de gaz 23 est prévue sur le côté opposé de ce volume inférieur 21 de la chambre de réaction 12. Ainsi, une circulation de gaz neutre peut être organisée dans le volume inférieur 21 de la chambre de réaction 12.

La présence de gaz neutre dans le volume inférieur 21 de la chambre de réaction 12 avait, initialement, pour mission d'éviter le dépôt sur la surface inférieure du support d'échantillon. Ici, la circulation de gaz neutre sert aussi à faire régner une pression P1 dans le volume inférieur 21, très légèrement supérieure à la pression P2 régnant dans le volume supérieur 22 où est créée une circulation de gaz actif. De cette manière, l'échantillon 11 est légèrement plaqué par son poids sur sa bague amovible 15 et les traitements à très basse pression, en l'occurrence en-dessous de 10 Torr (1 330 Pa) sont possibles. La différence de pression entre ces deux volumes 21 et 22 est réglée de manière à produire sur l'échantillon 1 une force verticale dirigée vers le haut à peine inférieure à son poids. On utilise à cet effet des moyens de mesure et des moyens de commande des pressions respectives des volumes supérieur 21 et inférieur 22.

Dans le cas décrit, cette légère différence de pression entre le volume inférieur 21 et le volume supérieur 22 est obtenue à l'aide de moyens de mesure de pression différentielle entre ces deux volumes, tels qu'une jauge de pression différentielle 24 reliée à la fois au volume inférieur 21 et au volume supérieur 22. Cette jauge différentielle 24 commande une première vanne 25 placée sur la sortie de gaz neutre 23 pour réguler la circulation de gaz neutre et donc la pression dans le volume inférieur 21, de manière à maintenir cette très légère différence de pression.

Ce moyen est notamment nécessaire lorsque l'écart de pression est très inférieur à la valeur absolue de la pression de part et d'autre de l'échantillon 11. On ne peut pas par exemple, en mesurant ces deux pressions P1 et P2 de part et d'autre de l'échantillon 11 (pressions de l'ordre de 10 Torr (1 330 Pa), réguler l'écart de pression de l'ordre de 0,01 Torr (10 Pa), à cause de la précision de tout instrument de mesure de pression en bas de son échelle de mesure.

La pression de fonctionnement P2 de la réaction chimique dans le volume supérieur 22 est mesurée grâce à une deuxième jauge de pression 26 des moyens de mesure de pression reliée directement au volume supérieur 22 et agissant sur une deuxième vanne de régulation 27 des moyens de commande de pression placée sur la sortie du gaz actif 18.

On comprend ainsi que la plupart des inconvénients énoncés dans le chapitre "Art antérieur et problèmes posés", provenant de la lame d'air entre l'échantillon et le support, soient supprimés grâce au fait de chauffer directement l'échantillon par rayonnement sur sa face inférieure, en supprimant son support, ou plus précisément, en utilisant un support creux, tels que la bague amovible 15 annulaire, ne supportant l'échantillon 11 que sur sa périphérie.

L'inconvénient inhérent au dépôt parasite sur les pièces mécaniques de maintien de l'échantillon ne concerne, dans le cas de l'invention, que la surface supérieure de la bague amovible 15. Or, cette dernière est chauffée pour l'essentiel par rayonnement et peut être réalisée en un matériau équivalent à celui qui constitue la paroi transparente inférieure 13 de la chambre de réaction 12 qui isole l'élément chauffant radiatif 14 de la chambre de réaction 12. Dans ce cas, la bague support 15 s'échauffe moins que l'échantillon 11 et se trouve à une température nettement inférieure. Elle peut également être réalisée dans le même matériau que l'échantillon 1, auquel cas elle reste un élément homogène par rapport à ce dernier, n'introduisant pas de réaction autre que celle se produisant sur l'échantillon 11.

Dans tous les cas, elle possède avec l'échantillon 11, qui est juste posé sur elle, un contact thermique beaucoup moins bon que dans le cas d'un système de serrage plaqué fortement contre celui-ci et donc un écart de température important avec celui-ci.

D'autre part, du fait qu'elle est déplacée en même temps que l'échantillon 11, lors du chargement et du déchargement de celui-ci dans la chambre de réaction 12, elle peut également être changée ou nettoyée pour chaque nouvel échantillon si elle était sujette au dépôt. Ceci éviterait l'accumulation de dépôt, responsable de la production de particules à l'intérieur de la chambre de réaction 12.

L'échantillon 11 peut être chauffé à des pressions inférieures à 10 Torr (1 330 Pa) du fait du chauffage radiatif. En effet, l'élément de chauffage est compatible pour une utilisation en pression de gaz ou sous vide, rendant ainsi possible la succession, dans une même chambre de réaction, d'un traitement sous gaz et d'un recuit sous vide.

Le rayonnement thermique absorbé par l'échantillon 11 est indépendant du procédé utilisé pour traiter sa surface supérieure, puisque le chauffage est effectué du côté de la face arrière de l'échantillon qui ne subit pas de transformation au cours du procédé. L'homogénéité de température sur l'échantillon est parfaite du fait que la bague amovible 15 qui, s'échauffant légèrement, limite les effets de bord. Ces derniers ont tendance à être reportés sur l'extrémité de la bague amovible 15 et non sur le bord de l'échantillon 11.

L'existence d'un volume de gaz neutre, dans le volume inférieur 21 en-dessous de l'échantillon 11, empêche tout dépôt sur la face arrière de ce dernier.

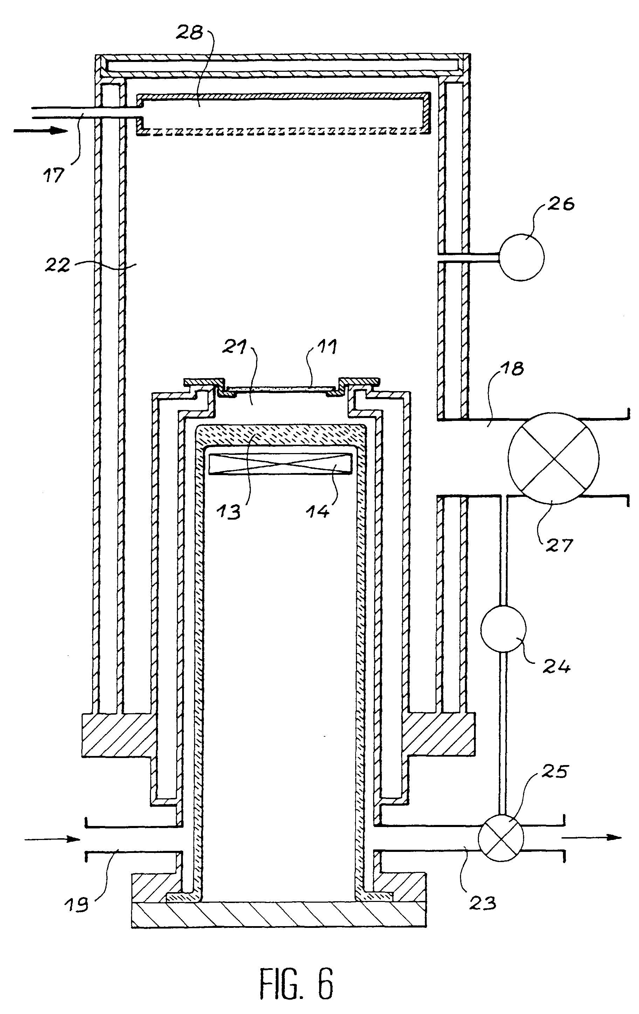

La figure 6 montre une réalisation possible du dispositif selon l'invention pour réaliser des dépôts de cuivre sur des échantillons constitués par des disques de silicium de 100 mm de diamètre et de 0,5 mm d'épaisseur. Le dépôt est obtenu par réaction en phase gazeuse d'un gaz actif précurseur organo-métallique de cuivre et de vapeur d'eau.

On a reporté sur cette figure 6 les mêmes références de la figure 5 aux éléments analogues. On y retrouve donc l'entrée de gaz actif 17 débouchant dans un injecteur de gaz actif 28. Ce dernier répand le gaz actif dans le volume supérieur 22. La sortie de gaz actif 18 placée sur le côté opposé de l'entrée de gaz actif 17 évacue ce dernier. Le volume inférieur 21 est beaucoup moins important que le volume supérieur 22, du fait que l'élément chauffant radiatif 14 est placé très près de l'échantillon 11, à quelques centimètres, grâce à la paroi inférieure 13 de la chambre de réaction 12 placée elle-même juste en-dessous de l'échantillon 11.

La circulation du gaz neutre se fait donc par une entrée inférieure de gaz neutre 19 dans le volume inférieur 21 qui se trouve autour de l'élément radiatif chauffant 14 et qui est également équipée d'une sortie de gaz neutre 23.

Sur cette figure est également symbolisée la jauge différentielle de mesure 24 et la première vanne de régulation 25 sur la sortie de gaz neutre 23.

La pression de réaction du gaz actif est, dans ce cas, de l'ordre de 0,5 Torr (66 Pa) et est régulée par une jauge de mesure de pression 26 de calibre 10 Torr (1 330 Pa). L'écart de pression entre le volume inférieur 21 et le volume supérieur 22 est régulé aux environs de 0,03 Torr (4 Pa) à l'aide de la jauge différentielle 24 de calibre 1 Torr (130 Pa) qui pilote la première vanne de régulation 25 placée sur la sortie de gaz neutre 23. Ce dernier peut être à cet effet de l'argon.

La force verticale appliquée à l'échantillon 11 vers le haut est de l'ordre de 3 g/force (0,03 Newton), alors que le poids des échantillons 11 utilisés est de l'ordre de 10 g/force. La force équivalente à la pression de 0,5 Torr (66 Pa) s'exerçant de part et d'autre de l'échantillon 11 est de l'ordre de 50 g/force (0,5 Newton).

L'élément chauffant radiatif 14 peut être en graphite et alimenté en puissance par 400 W dans les conditions habituelles du traitement qui se fait à une température d'échantillon de l'ordre de 250° C. L'écart maximum de température sur l'échantillon, mesuré à l'aide d'un échantillon équipé de thermocouples est alors de 5,7° C, ce qui représente une variation d'homogénéité de 2,3 %.

On précise que le dispositif décrit ici a déjà été utilisé pour un tel traitement sur des substrats de silicium et des recuits à des pressions de l'ordre de l'ultra-vide, environ 8.10⁻¹¹ Torr (10⁻⁸ Pa). Plus d'une centaine de dépôts a été réalisée.

Le dispositif selon l'invention permet d'effectuer des dépôts jusqu'à une température de 1000°C.

L'exemple décrit ici concerne le traitement d'une seule surface de l'échantillon. On envisage également de traiter les deux surfaces de cet échantillon en utilisant un deuxième gaz actif à la place du gaz neutre dans le volume inférieur 21.

L'utilisation de moyens de mesure et de commande des pressions respectives des volumes inférieur et supérieur permet d'appliquer de nombreux traitements chimiques aux échantillons traités mettant en oeuvre des pressions très diverses.

## Revendications

1. Dispositif de traitement chimique superficiel à température élevée d'un échantillon plat (11) au moyen d'un gaz actif par réaction, le dispositif comprenant :
- une chambre de réaction (12) ;
- un support d'échantillon (16) placé dans la chambre de réaction (12) constitué d'un épaulement annulaire entièrement fixé à la paroi intérieure de la chambre de réaction (12) et sur lequel l'échantillon (11) doit être posé pour partager l'intérieur de la chambre de réaction (12) en deux volumes séparés, un volume supérieur (22) et un volume inférieur (21) de la chambre de réaction (12) ;
- des moyens de circulation d'un premier gaz dans le volume supérieur sur une première surface à traiter de l'échantillon (11) ;
- des moyens de circulation d'un deuxième gaz dans le volume inférieur (21) sur une deuxième surface à traiter de l'échantillon ; et
- un élément chauffant radiatif (14) placé à l'extérieur et près de la chambre de réaction (12), caractérisé en ce qu'il comprend des moyens de mesure (24) et des moyens de commande (25, 27) des pressions respectives des volumes inférieur (21) et supérieur (22) pour asservir les pressions dans ces volumes supérieur (22) et inférieur (21) avec le traitement chimique à appliquer à l'échantillon.

2. Dispositif de traitement selon la revendication 1, caractérisé en ce que dans le volume inférieur (21) de la chambre de réaction (12) les moyens de commande de pression sont constitués par une première vanne de régulation (25) pour asservir la pression P1 dans le volume inférieur (21).

3. Dispositif de traitement selon la revendication 2, caractérisé en ce que les moyens de commande de pression sont constitués, dans le volume supérieur (22), d'une deuxième vanne de régulation (27) sur la sortie de gaz actif (18), pour asservir la pression P2 de réaction dans le volume supérieur (22).

4. Dispositif de traitement selon la revendication 3, caractérisé en ce que la pression de circulation (PS) du premier gaz dans le volume supérieur (22) est très légèrement inférieure à la pression (P1) du deuxième gaz dans le volume inférieur (21) de la chambre de réaction (12), de sorte que l'échantillon soit soumis à une force verticale vers le haut juste inférieure à son poids.

5. Dispositif de traitement selon la revendication 4, caractérisé en ce que le premier gaz est un gaz actif et le deuxième gaz est un gaz neutre, pour n'agir que sur la surface supérieure de l'échantillon (11).

6. Dispositif de traitement selon la revendication 1, caractérisé en ce que l'élément chauffant radiatif (14) est placé en-dessous d'une paroi inférieure (13) de la chambre de réaction (12) se trouvant elle-même juste en-dessous du support (16) qui supporte l'échantillon (11).

7. Dispositif de traitement selon la revendication 6, caractérisé en ce que la paroi inférieure (13) de la chambre de réaction (12) est en un matériau fortement transparent aux longueurs d'ondes du rayonnement émis par l'élément chauffant radiatif (14).

8. Dispositif de traitement selon la revendication 1, caractérisé en ce qu'il comprend une bague amovible (15) placée sur l'épaulement annulaire (16) et supportant l'échantillon (11).

9. Dispositif de traitement selon la revendication 8, caractérisé en ce que la bague amovible (15) est transparente.
